# EUROPÄISCHE PATENTSCHRIFT

(11) **EP 1 985 166 B1**
(45) Veröffentlichungstag und Bekanntmachung des Hinweises auf die Patenterteilung: **10.04.2013**
(21) Anmeldenummer: 07722797.3
(22) Anmeldetag: 10.02.2007
(51) Int. Cl.: H05K 9/00

(54) **ABSCHIRMGEWEBE**
SCREENING FABRIC
TISSU DE BLINDAGE

(30) Priorität: 16.02.2006 DE 102006007518
(43) Veröffentlichungstag der Anmeldung: 29.10.2008
(73) Patentinhaber: Haver & Boecker oHG, 59302 Oelde (DE)
(72) Erfinder: HAVER, Walter, 59302 Oelde (DE); MEYER, Frank, 49196 Bad Laer (DE); BUTENKEMPER, Stefan, 48234 Sendenhorst (DE)
(74) Vertreter: Schütte, Hartmut
(86) Internationale Anmeldenummer: PCT/EP2007/001144
(87) Internationale Veröffentlichungsnummer: WO 2007/093331

(56) Entgegenhaltungen:
- EP-A- 1 148 774
- EP-A1- 1 176 610
- DE-A1-102004 015 972
- DE-U1- 20 013 839
- DE-U1- 20 021 305
- DE-U1- 20 307 223
- DE-U1- 20 311 375
- US-A- 1 696 411
- US-A- 4 557 968

## Beschreibung

Die vorliegende Erfindung betrifft ein Abschirmgewebe, welches zum großflächigen Einsatz in bzw. an faserverstärkten Bauteilen und Einrichtungen geeignet ist, um elektromagnetische Strahlung abzuschirmen. Die Erfindung betrifft weiterhin eine mit einem Abschirmgewebe versehene Wandung bzw. ein damit ausgerüstetes Bauteil.

Es sind als Drahtgewebe ausgeführte Abschirmgewebe im Stand der Technik bekannt geworden, wobei zwischen zwei Lagen eines Verbundwerkstoffes ein Laminat mit einem Drahtgewebe eingebracht wird, um eine Abschirmung von elektromagnetischer Strahlung zu bewirken. Dabei wird das Laminat zunächst aus dem Drahtgewebe und mehreren unterschiedlichen Schichten angefertigt, bevor es zur Herstellung des Bauteils zwischen die zwei faserverstärkten Schichten eingebracht wird, die dann später von beiden Seiten des fertigen Bauteils aus sichtbar sind.

Eine so hergestellte Abschirmwandung bzw. ein so hergestelltes Bauteil kann auch hohe Anforderungen hinsichtlich der Stabilität und der elektrischen Abschirmwirkung erfüllen. Bei einfachen ebenen Flächen genügt es auch den optischen Ansprüchen an solche Bauteile. Nachteilig ist aber, dass sich konventionelles Drahtgewebe insbesondere an dreidimensional gebogenen Flächen und Vorsprüngen oft nur unbefriedigend an die dreidimensionale Oberflächenstruktur anpasst, da die Drapierbarkeit des Drahtgewebes nicht ausreichend ist. Es können Falten im Drahtgewebe entstehen, die oftmals später auf der fertigen Oberfläche des Faserverbundwerkstoffs sichtbar bleiben. Das kann dazu führen, dass solche Bauteile für die Verwendung an sichtbaren Stellen im Flugzeug- oder Fahrzeugbau ungeeignet sind.

Mit der US 1,696,411 ist ein Abschirmgewebe für Radiogeräte bekannt geworden, welches zwischen elektrischen Leitern auch nicht-leitende Fäden aufweist. Das Gewebe weist eine Leinenbindung auf. Dadurch eignet sich das Abschirmgewebe zur Bespannung von ebenen Gehäuseflächen von Radiogeräten.

Mit der DE 200 21 305 U1 ist ein flächiges Gewebeelement bekannt geworden, bei dem der zentrale Gewebebereich mit einer Leinenbindung versehen ist und bei dem Randbereiche mit anderen Bindungsarten versehen sind. Das Gewebeelement besteht aus Kettfäden und quer dazu verlaufenden Schussfäden. In einer Richtung sind die Fäden elektrisch leitfähig ausgebildet. Die quer dazu verlaufenden Fäden bestehen aus einem elektrisch leitfähigen Material und weisen eine isolierende Umhüllung auf. An zwei gegenüberliegenden Randbereichen sind die Fäden vereinzelt und können zur Verbindung mit elektronischen Bauteilen vorgesehen sein. Es ist auch möglich, dass ein endloser Schussfaden vorgesehen ist, der dann in einem Isoliergewebe als Widerstandsdraht genutzt werden kann. Das Gewebe eignet sich auch für die Anwendung bei flachen Körpern.

Es ist deshalb die Aufgabe der Erfindung, ein weiteres Abschirmgewebe zur Verfügung zu stellen, welches eine bessere Drapierbarkeit des Drahtgewebes erlaubt. Ein weiterer Aspekt ist es, eine mit einem Abschirmgewebe ausgerüstete Wandung zur Verfügung zu stellen, bei dem ein Faltenwurf des Drahtgewebes des Abschirmgewebes reduziert ist.

Die Aufgabe wird erfindungsgemäß durch ein Abschirmgewebe mit den Merkmalen des Anspruchs 1 und durch eine Wandung mit den Merkmalen des Anspruchs 14 gelöst. Bevorzugte Weiterbildungen und Ausgestaltungen sind Gegenstand der Unteransprüche.

Das erfindungsgemäße Abschirmgewebe weist ein aus Fäden über einer ausgedehnten Gewebefläche durchgängig gewebtes Drahtgewebe auf. Die Fäden des Drahtgewebes umfassen Kettfäden und quer dazu verlaufende Schussfäden. Die Kett- und die Schussfäden sind über wenigstens eine Bindungsart miteinander verbunden. Wenigstens ein Teil der Kettfäden und der Schussfäden besteht aus Metall und die Kettfäden und die Schussfäden sind elektrisch leitend verbunden. Das Drahtgewebe weist eine Bindungsart auf, welche eine gegenüber einer Leinenbindung erhöhten Drapierbarkeit aufweist und auf einer Atlasbindung und/oder einer Köperbindung beruht. Ein Teil der Fäden besteht wenigstens teilweise aus einem Nichtmetall, um die Drapierbarkeit des Drahtgewebes zu erhöhen.

Die Erfindung hat viele Vorteile. Überraschend hat sich heraus gestellt, dass Fäden aus Nichtmetall zwischen Fäden aus Metall eine erhebliche Flexibilisierung des Abschirmgewebes mit sich bringen.

Dabei besteht das Nichtmetall vorzugsweise aus einem Stoff, der sich gut mit einer Grundplatte verbinden lässt, auf der das Drahtgewebe später angebracht werden soll. Die elektromagnetische Strahlung wird zuverlässig durch die metallischen Fäden abgeschirmt und durch das Drahtgewebe abgeleitet. Die nichtmetallischen Fäden erhöhen die Verformbarkeit und die Anpassbarkeit an dreidimensionale Formen erheblich, so dass eine flexible und faltenfreie Herstellung von abschirmenden Bauteilen möglich ist.

Die erhöhte Drapierbarkeit bewirkt, dass das Aufbringen des Abschirmgewebes auf gekrümmte Oberflächen leichter ist und gleichzeitig die Qualität der Oberfläche gesteigert werden kann, da ein Faltenwurf in vielen Fällen vermieden wird, während andererseits eine genügende Abschirmwirkung erzielt wird.

Insbesondere ist wenigstens ein flächiger Bereich des Drahtgewebes mit einer Bindungsart versehen, der eine erhöhte Drapierbarkeit und/oder Verformbarkeit erlaubt. Das ist sehr vorteilhaft, da so eine besonders hohe Anpassung des Abschirmgewebes an eine gekrümmte Oberfläche erzielt wird.

Insbesondere eine Atlasbindung und davon abgeleitete Bindungen führen zu einer deutlich erhöhten Drapierbarkeit gegenüber einem mit einer Leinenbindung gewebtem Abschirmgewebe mit ansonsten vergleichbaren Gewebewerten.

Besonders bevorzugt sind Weiterbildungen der Erfindung, bei denen eine Waffelbindung eingesetzt wird bzw. bei denen eine auf einer Waffelbindung beruhende Bindungsart eingesetzt wird. Eine Waffelbindung weist ein honigwabenartiges Relief und durch die hohen Flottungen der Fäden bedingt eine gute Drapierbarkeit auf. Ähnliches gilt auch für eine Spitzköperbindung, die ebenfalls hohe Flottungen und eine gute Drapierbarkeit aufweist.

In bevorzugten Weiterbildungen besteht wenigstens ein Teil der Kett- und der Schussfäden wenigstens teilweise aus einem Nichtmetall, insbesondere bestehen einige Fäden vollständig oder doch im Wesentlichen vollständig aus einem Nichtmetall. Die Fäden aus Nichtmetall dienen zur Fixierung der anderen Fäden und erlauben im späteren Weiterverarbeitungsprozess eine hohe Bindung zwischen Grundplatte und Drahtgewebe, die auch auf der Durchdringung der Materialien beruht. In allen Fällen kann ein Nichtmetall eingesetzt werden oder es können auch mehrere unterschiedliche Nichtmetalle verwendet werden.

Ein erheblicher Nachteil bei den im Stand der Technik verwendeten Laminaten ist der hohe Arbeitsaufwand bei der Herstellung und Verbindung der einzelnen Schichten des Laminats und der Wandung bzw. des Bauteils. Das liegt daran, dass die Drahtgewebeschicht und die weiteren mehreren unterschiedlichen Schichten einzelnen separat hergestellt und anschließend aufwändig miteinander verbunden werden müssen. Das erfordert einen erheblichen Personal- bzw. Maschinen- und Zeitaufwand.

Mit dem erfindungsgemäßen Abschirmgewebe wird das Abschirmgewebe hingegen direkt in einem Schritt hergestellt. Es ist nach dem Weben des Drahtgewebes direkt eine Weiterverarbeitung möglich. Eine separate Behandlung und ein zusätzlicher Verbindungsschritt ist nicht nötig. Das bietet ganz erhebliche Vorteile gegenüber dem bisherigen Stand der Technik. Die Anmelderin weist deshalb darauf hin, dass erfindungsgemäß auch bei durchschnittlicher Drapierbarkeit des Drahtgewebes erhebliche Vorteile erzielt werden.

In allen Ausgestaltungen ist es bevorzugt, dass wenigstens einige Fäden wenigstens teilweise aus einem Kunststoff bestehen.

Insbesondere bestehen wenigstens einige der Fäden vollständig oder doch im Wesentlichen vollständig aus einem Kunststoff. Vorzugsweise werden thermoplastische Kunststoffe, wie z.B. Polyester, Polyethylen oder Polyamide eingesetzt. Solche thermoplastischen Werkstoffe können bei hohen Temperaturen geschmolzen werden, um eine feste Verbindung mit den Grundplatten bzw. Grundschichten zu ermöglichen. Geeignete Temperaturen hängen vom verwendeten Werkstoff ab und liegen z.B. bei Polyamid bei ca. 215 °C und bei Polyethylen bei etwa 100 - 150 °C.

Die Nichtmetallfäden erhöhen die Fixierbarkeit der Kreuzungspunkte erheblich. Insbesondere Kunststofffäden tragen so einen bedeutenden Beitrag zur Stabilität bei.

In bevorzugten Ausgestaltungen können einige Fäden auch einen faserverstärkten Kern und einen Mantel aus einem thermoplastischen Werkstoff aufweisen.

Grundsätzlich weist das Drahtgewebe immer auch metallische Fäden auf, da die abschirmende Wirkung durch die elektrische Leitfähigkeit der Metallfäden gewährleistet wird. In bevorzugten Weiterbildungen weisen einige Fäden einen metallischen Kern und einen Mantel aus einem Nichtmetall auf.

Die Kettfäden und die Schussfäden sind elektrisch leitend verbunden. Das ist in der Regel ein wesentlicher Punkt eines Abschirmgewebes, da elektromagnetische Strahlung entsprechender Frequenz nur dann zuverlässig abgehalten wird, wenn der Abstand der Kontaktpunkte zwischen den einzelnen Fäden nicht zu groß ist.

Grundsätzlich können einige Fäden auch aus einem Metallkern und einem Kunststoffmantel bestehen.

In bevorzugten Weiterbildungen sind in periodischen Abständen Fäden aus einem Nichtmetall vorgesehen. Z.B. kann in Kett- und in Schussrichtung jeder zweite oder jede dritte oder jeder vierte Kett- und/oder Schussfaden aus Kunststoff bestehen. Vorzugsweise besteht jeder zweite Faden aus einem Kunststoff. Möglich sind auch periodische Muster. So können in einem größeren Muster z.B. zunächst zwei Kunststofffäden vorgesehen sein, an die sich zwei Metallfäden anschließen u.s.w. In anderen Ausgestaltungen können auch kompliziertere Muster vorgesehen sein, z.B. zunächst zwei Kunststofffäden, dann einer aus Metall, danach einer aus Kunststoff und schließlich zwei aus Metall, worauf sich die Reihenfolge wiederholt.

In allen Ausgestaltungen ist das Drahtgewebe insbesondere bereichsweise homogen.

Es sind auch Ausgestaltungen möglich und bevorzugt, bei denen mehrere Bereiche oder Abschnitte jeweils homogen vorgesehen sind. Das kann z.B. über bereichsweise unterschiedliche Bindungsarten über der Fläche realisiert sein. Eine mögliche Anwendung ist z.B. die spezifisch zugeschnittene Herstellung von Abschirmgeweben, bei denen der abzuschirmende Körper eine größere ebene Fläche und sich daran anschließende stärkere Wölbungen aufweist. Für die unterschiedlichen Flächesegmente kann das Gewebe dann entsprechend angepasst hergestellt werden.

Um Faltenbildungen zu vermeiden, kann in gekrümmten bzw. gewölbten Bereichen die Bindungsart des Gewebes unterstützend angepasst werden, indem dort eine Bindungsart gewählt wird, die eine größere Drapierbarkeit erlaubt, während auf ebenen Flächen eine Bindungsart mit geringerer Drapierbarkeit gewählt wird. Bevorzugt wird in gewölbten Bereichen eine Waffelbindung oder dergleichen verwendet, während für ebene Flächen auch eine Leinenbindung möglich ist. Dadurch wird ein Faltenwurf zuverlässig vermieden.

Grundsätzlich hängen die Maschenweite des Gewebes, sowie die verwendeten Drahtdurchmesser der Metallfäden und der Nichtmetallfäden von dem Anwendungsfall ab und können dementsprechend unterschiedlich sein.

Möglich sind in einzelnen Ausgestaltungen Maschenweiten von bis zu 10 oder 15 mm bei Drahtdurchmessern von bis zu 1 oder 2 mm.

In bevorzugten Ausgestaltungen und Weiterbildungen ist der typische Durchmesser der eingesetzten Kunst- und/oder Naturstofffäden kleiner 500 µm, insbesondere kleiner 250 µm und vorzugsweise kleiner als 150 µm.

Der typische Durchmesser der eingesetzten Metallfäden ist insbesondere kleiner 500 µm, vorzugsweise kleiner 150 µm und besonders bevorzugt kleiner 100 µm.

In bevorzugten Ausgestaltungen ist die Maschenweite des Gewebes kleiner 500 µm, insbesondere kleiner 200 µm und vorzugsweise kleiner oder gleich 150 µm.

In besonders bevorzugten Ausgestaltungen liegt die Maschenweite bei etwa 150 µm und der Durchmesser der Metallfäden bei etwa 30 bis 50 µm. Vorzugsweise ist die Anzahl der Maschen pro Zoll Länge kleiner 200 und/oder größer 50.

Alle zuvor angegebenen Zahlenwerte sind als Richtwerte anzusehen, so dass Abweichungen nach oben und unten möglich sind, insbesondere um 20 %.

In bevorzugten Ausgestaltungen und Weiterbildungen können zusätzliche Fäden aus Kunststoff vorgesehen sein, die dann benachbart zu Metallfäden in Kett- und/oder Schussrichtung angeordnet sind. Insbesondere liegen die zusätzlichen Fäden dicht an Metallfäden an.

Vorzugsweise bestehen wenigstens einige Fäden oder Metallfäden des Drahtgewebes wenigstens teilweise aus einem Material, welches einer Gruppe von Materialien entnommen ist, die Zinnbronze, Stahl, Edelstahl, Messing, Kupfer, Titan, Gold, Silber und Aluminium und dergleichen mehr umfasst. Insbesondere ist auch der Einsatz von Metalllegierungen oder von Metallgemischen möglich.

In bevorzugten Ausgestaltungen bestehen wenigstens einige Fäden aus einem Multifilament, welches insbesondere wenigstens teilweise homogene Drähte, Zwirn, Metallfasergarn, Seile und/oder Litzen umfasst.

Die Erfindung ist auch auf eine Wandung oder ein Bauteil ausgerichtet, welches wenigstens eine faserverstärkte Außenschicht umfasst, das ein Abschirmgewebe aufweist, wie es zuvor beschrieben wurde.

Der Einsatz der Erfindung kann an allen möglichen Vorrichtungen erfolgen. Bevorzugt ist die Verwendung an Bauteilen von Kraftfahrzeugen, wie z.B. an bzw. in Motorhauben, Türen, Dächern, Kotflügeln. Ebenso kann das Abschirmgewebe an Windrädern als Blitzschutz eingesetzt werden. Die Verwendung kann auch im Flugzeugbau erfolgen, bei dem Rumpfbauteile oder die Tragflächen mit einem Abschirmgewebe versehen werden. Insbesondere erfolgt der Einsatz bei Bauteilen aus faserverstärkten Kunststoffen, um dort die Funktion des Shieldings zu bewirken.

Weitere Merkmale, Eigenschaften und Vorteile der vorliegenden Erfindung ergeben sich aus der nachfolgenden Beschreibung der Ausführungsbeispiele unter Bezugnahme auf die beiliegenden Zeichnungen.

Darin zeigt:
- Fig. 1: eine stark schematische Aufsicht auf ein Abschirmgewebe mit einer Atlasbindung;
- Fig. 2: eine stark schematische Aufsicht auf ein Abschirmgewebe mit einer Köperbindung; und
- Fig. 3: eine stark schematische Aufsicht auf ein weiteres Abschirmgewebe mit einer Köperbindung.

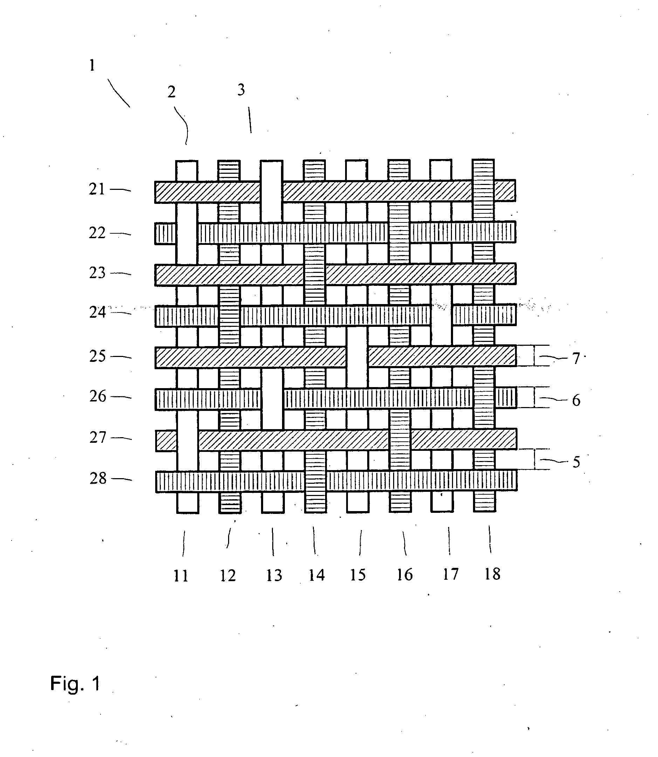

Mit Bezug auf die beiliegende Figur 1 wird nun ein erstes Ausführungsbeispiel eines erfindungsgemäßen Abschirmgewebes 1 beschrieben.

Das in Fig. 1 stark schematisch dargestellte erfindungsgemäße Abschirmgewebe 1 umfasst in Gewebelängsrichtung Kettfäden 11 bis 18 und quer dazu Schussfäden 21 bis 28. Der Übersichtlichkeit halber sind in den Figuren nur einige wenige Kett- und Schussdrähte eingezeichnet.

Die Bindungsart des Drahtgewebes ist hier eine Atlas-1/4-Bindung, d. h. hier, dass ein Schussfaden 21 unterhalb des Kettfadens 13, dann oberhalb von vier Kettfäden 14 bis 17, danach unterhalb des folgenden Kettfadens 18 und dann wieder oberhalb vier weiterer Kettfäden (nicht dargestellt) verläuft. So liegt ein regelmäßiges Muster vor, welches sich hier nach jeweils fünf Kettfäden wiederholt. Genauso ist z.B. auch eine Atlas-1/3-Bindung möglich, bei der eine sich das Muster nach vier Fäden wiederholt. Auch andere größere oder kleinere Rapports sind möglich.

Der Verlauf des nächsten Schussfadens 22 ist um zwei Kettfäden versetzt angeordnet, so dass der Schussfaden 22 unterhalb des Kettfadens 11, dann oberhalb der vier folgenden Kettfäden 12 bis 15, wieder unterhalb des Kettfadens 16 und danach wieder oberhalb der vier folgenden Kettfäden 17 etc. verläuft.

Der Verlauf des dritten Schussfadens 23 ist wiederum um zwei Kettfäden versetzt angeordnet, so dass der Schussfaden 23 oberhalb der Kettfäden 11 bis 13, unterhalb des Kettfadens 14 und wieder oberhalb der Kettfäden 15 bis 18 verläuft.

Dementsprechend verläuft der vierte Schussfaden 24 unterhalb der in Figur sichtbaren Kettfäden 12 und 17 und oberhalb der Kettfäden 11, sowie 13 bis 16 und 18 und der fünfte Schussfaden 25 verläuft oberhalb der Kettfäden 11 bis 14 und 16 bis 18 und unterhalb des Kettfadens 15.

Der sechste Schussfaden 26 weist einen Verlauf wie der erste Schussfaden 21 auf, da sich bei der hier gezeigten Atlas 1/4-Bindung das Muster nach fünf Kett- bzw. Schussfäden wiederholt. Ebenso entspricht der Verlauf des Schussfadens 27 dem des Schussfadens 22 und die Verläufe der Schussfäden 28 und 23 stimmen ebenfalls überein.

Die hier als Bindungsart gewählte Atlasbindung erlaubt eine weitgehende Drapierbarkeit des Drahtgewebes 2, so dass das Drahtgewebe 2 gut an gekrümmte Flächen angepasst werden kann, ohne dass ein störender Faltenwurf entsteht. So kann ein hochwirksames Abschirmgewebe in eine gekrümmte Oberfläche aus einem Faserverbundwerkstoff integriert werden, wobei eine optisch ansprechende Oberfläche erzielbar ist.

Die einzelnen Fäden des Drahtgewebe 2 bestehen hier abwechselnd aus Metall und aus einem thermoplastischem Kunststoff, wie z.B. Polyester oder Polyamid. Hier bestehen die Kettfäden 11, 13, 15 und 17 aus Metall und sind in Fig.1 unschraffiert dargestellt, während die dazwischen liegenden Kettdrähte 12, 14 und 16, sowie der Draht 18 aus Kunststoff bestehen. Die Kunststofffäden sind in der Darstellung nach Fig. 1 schraffiert dargestellt, wobei die Schraffur jeweils senkrecht zur Längsachse der jeweiligen Fäden ausgerichtet ist.

Die Schussfäden 21, 23, 25 und 27 sind hier im Ausführungsbeispiel ebenfalls als Metalldrähte ausgeführt und hier schraffiert eingezeichnet, wobei die Schraffurlinien um 45° zur Längsrichtung der jeweiligen Fäden ausgerichtet sind. Auch bei den Schussfäden wechseln sich hier Metall- und Kunststofffäden miteinander ab, so dass die Schussfäden 22, 24, 26 und 28 als Kunststofffäden ausgeführt sind.

Die abwechselnde Anordnung von Metallfäden und Kunststofffäden erhöht die Stabilität des Gewebes und führt außerdem zu einer erheblich verbesserten Drapierbarkeit des Gewebes, wobei gleichzeitig eine ausreichende Abschirmwirkung gewährleistet wird. Die Kunststofffäden bewirken eine zusätzliche Fixierung des Gewebes.

Der Durchmesser 7 der verwendeten Metallfäden betragen hier im Ausführungsbeispiel je nach Anwendungsfall etwa zwischen 30 und 70 µm, typischerweise 50 µm. Der Durchmesser 6 der eingesetzten Kunststofffäden liegt typischerweise zwischen etwa 50 und 200 µm, typisch bei ungefähr 80 bis 150 µm. Die Maschenweite 5 zwischen den Metall- und Kunststofffäden hängt vom Einsatzweck ab und kann z.B. zwischen 30 µm und 150 µm liegen. Die Maschenweite zwischen zwei Metallfäden kann zwischen 50 und 200 µm betragen, typisch etwa 140 oder 150 µm. Die genaue Maschenweite hängt von der geforderten Abschirmwirkung und dem abzuschirmendem Frequenzbereich ab.

Vorzugsweise sind die Metallfäden aus Zinnbronze, gegebenenfalls auch aus Stahl oder Edelstahl. Es kann auch Kupfer eingesetzt werden.

Das erfindungsgemäße Abschirmgewebe 1 bietet erhebliche Vorteile gegenüber dem Stand der Technik, da eine schnellere und kostengünstigere Fertigung von Wandungen oder Bauteilen aus Faserverbundwerkstoffen möglich ist, bei denen ein Drahtgewebe 2 zur Abschirmung elektromagnetischer Strahlung eingesetzt wird.

Die erfindungsgemäße Verwendung von Fäden aus einem Kunststoffmaterial wie Polyester oder Polyamid erlaubt die Herstellung hochdrapierbarer Drahtgewebe, die sich gut an gekrümmte Oberflächen anpassen bzw. darin integrieren lassen.

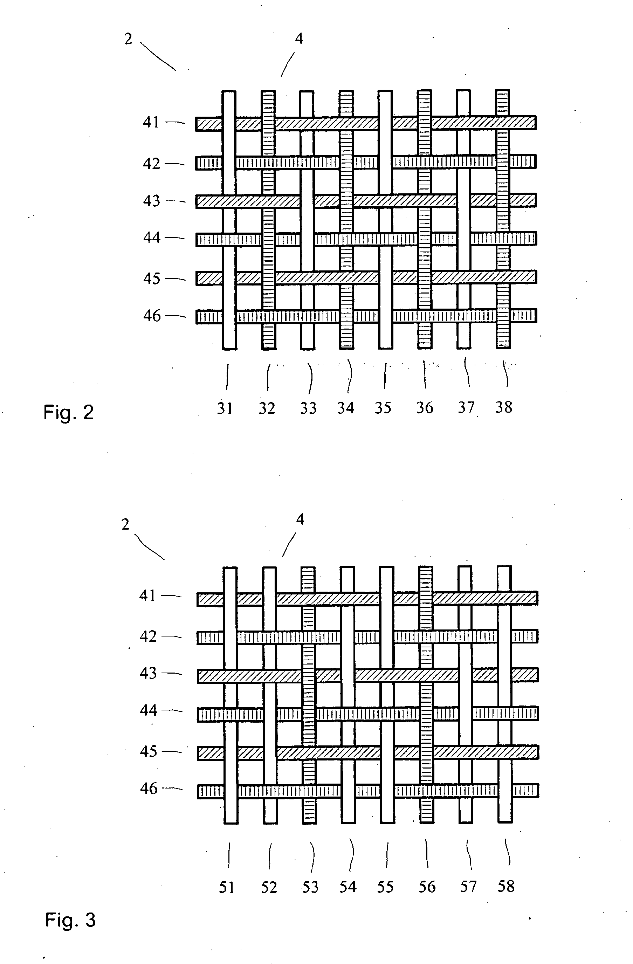

In Fig. 2 ist ein zweites Ausführungsbeispiel eines Abschirmgewebes 1 stark schematisch in einer Aufsicht dargestellt. Auch hier besteht nur jeder zweite Kettfaden 31, 33, 35 und 37 und jeder zweite Schussfaden 41, 43, 45 und 47 aus Metall, während die dazwischen liegenden Kettfäden 32, 34, 36 und 38, sowie die Schussfäden 42, 44 und 46 aus einem thermoplastischen Kunststoff bestehen.

Im Unterschied zum Ausführungsbeispiel nach Figur 1 weist das Gewebe 2 im Ausführungsbeispiel nach Figur 2 als Bindungsart eine Köperbindung auf. Auch die Köperbindung erlaubt eine vernünftige Drapierbarkeit des Drahtgewebes. In anderen Ausgestaltungen kann insbesondere auch ein Waffelbindung vorgesehen sein, die eine besonders gute Drapierbarkeit erlaubt.

Bei der in Figur 3 stark schematisch dargestellten Aufsicht auf ein Drahtgewebe 2 liegt wiederum als Bindungsart die Köperbindung vor, wie sie auch bei dem Drahtgewebe nach Figur 2 vorliegt. Im Unterschied zu den anderen Ausführungsbeispielen ist hier aber nur jeder dritte Kettdraht aus einem Kunststoff, so dass die Kettdrähte 51 und 52, 54 und 55 und 57 und 58 aus Metall sind, während die Kettfäden 53 und 56 aus einem Kunststoff bestehen. Hier im Ausführungsbeispiel ist jeder zweite Schussdraht 42, 44 und 46 aus Kunststoff, während die Schussdrähte 41, 43 und 45 aus Metall sind.

In anderen Ausgestaltungen ist es bevorzugt, dass nur in Kett- oder nur in Schussrichtung Kunststoffdrähte vorgesehen sind.

In anderen bevorzugten Ausgestaltungen sind in einem regelmäßigen Drahtgewebe aus Metallfäden einige zusätzliche Kett- und/oder Schussfäden aus Kunststoff vorgesehen, die dann zwischen einzelnen Kett- und/oder Schussfäden aus Metall angeordnet sind. Beispielsweise können die zusätzlichen Kunststofffäden zur Fixierung einzelner Kettdrähte (oder Schussdrähte) eingesetzt werden. Solche zusätzlichen Fäden (Kett- und/oder Schussfäden) aus Kunststoff können dicht an einzelnen Metallfäden anliegen. Dann entspricht der Abstand zwischen den Metallfäden der Maschenweite des Metallgitters, während der Abstand zwischen den Kunststofffäden und den benachbarten Metallfäden nahezu Null oder gleich Null sein kann.'

In allen Ausgestaltungen können die Kunststofffäden nicht nur aus einem thermoplastischem Werkstoff bestehen, sondern können einen Kern aus einer Karbonfaser oder dergleichen enthalten, um die herum ein Mantel aus einem thermoplastischem Werkstoff vorgesehen ist.

Die erfindungsgemäße Wandung bzw. das erfindungsgemäße Bauteil umfasst insbesondere einen flächige Abschnitt aus einem Faserverbundwerkstoff, in den ein Abschirmgewebe integriert ist, um elektromagnetische Strahlung abzuhalten.

## Patentansprüche

1. Abschirmgewebe (1) mit einem aus Fäden (11-18, 21-28) über einer ausgedehnten Gewebefläche durchgängig gewebten Drahtgewebe (2), wobei die Fäden Kettfäden (11-18) und quer dazu verlaufende Schussfäden (21-28) umfassen und die Kettfäden und die Schussfäden über wenigstens eine Bindungsart miteinander verbunden sind, **dadurch gekennzeichnet,**
**dass** wenigstens ein Teil der Kettfäden (11, 13, 15, 17) und der Schussfäden (21, 23, 25, 27) aus Metall besteht,
und **dass** die Kettfäden (11, 13, 15, 17) und die Schussfäden (21, 23, 25, 27) elektrisch leitend verbunden sind,
und **dass** das Drahtgewebe (2) eine Bindungsart aufweist, welche eine gegenüber einer Leinenbindung erhöhten Drapierbarkeit aufweist und auf einer Atlasbindung (3) und/oder Köperbindung (4) beruht,
und **dass** ein Teil der Fäden (12, 14, 16, 18, 22, 24, 26, 28) wenigstens teilweise aus einem Nichtmetall besteht, um die Drapierbarkeit des Drahtgewebes (2) zu erhöhen.

2. Abschirmgewebe (1) nach Anspruch 1, **dadurch gekennzeichnet, dass** die Bindungsart auf einer Waffelbindung beruht.

3. Abschirmgewebe (1) nach mindestens einem der vorhergehenden Ansprüche, **dadurch gekennzeichnet, dass** ein Teil der Kettfäden und ein Teil der Schussfäden wenigstens teilweise aus einem Nichtmetall besteht, wobei insbesondere einige Fäden (12, 14, 16, 18, 22, 24, 26, 28) im wesentlichen vollständig aus einem Nichtmetall bestehen.

4. Abschirmgewebe (1) nach mindestens einem der vorhergehenden Ansprüche, **dadurch gekennzeichnet, dass** einige Fäden (12, 14, 16, 18, 22, 24, 26, 28) wenigstens teilweise aus einem Kunststoff bestehen.

5. Abschirmgewebe (1) nach Anspruch 4, **dadurch gekennzeichnet, dass** einige Fäden einen faserverstärkten Kern und einen Mantel aus einem thermoplastischen Werkstoff aufweisen.

6. Abschirmgewebe (1) nach mindestens einem der vorhergehenden Ansprüche, **dadurch gekennzeichnet, dass** ein Teil der Fäden einen metallischen Kern und einen Mantel aus einem Nichtmetall aufweist.

7. Abschirmgewebe (1) nach mindestens einem der vorhergehenden Ansprüche, **dadurch gekennzeichnet, dass** in periodischen Abständen Fäden aus einem Nichtmetall vorgesehen sind.

8. Abschirmgewebe (1) nach mindestens einem der vorhergehenden Ansprüche, **dadurch gekennzeichnet, dass** das Drahtgewebe (2) bereichsweise homogen ist.

9. Abschirmgewebe (1) nach mindestens einem der vorhergehenden Ansprüche, **dadurch gekennzeichnet, dass** der Durchmesser (6) von Kunst- und/oder Naturstofffäden (26) kleiner 500 µm, insbesondere kleiner 250 µm, vorzugsweise kleiner 150 µm ist.

10. Abschirmgewebe nach mindestens einem der vorhergehenden Ansprüche, **dadurch gekennzeichnet, dass** der Durchmesser (7) von Metallfäden (25) kleiner 500 µm, insbesondere kleiner 150 µm, vorzugsweise kleiner 100 µm ist und/oder wobei vorzugsweise eine Maschenweite (5) kleiner 500 µm und insbesondere kleiner 200 µm und vorzugsweise kleiner 150 µm ist.

11. Abschirmgewebe (1) nach Anspruch 10, **dadurch gekennzeichnet, dass** die Maschenweite (5) bei etwa 150 µm und der Durchmesser (7) der Metallfäden (25) bei etwa 50 µm liegt.

12. Abschirmgewebe (1) nach mindestens einem der vorhergehenden Ansprüche, **dadurch gekennzeichnet, dass** eine Anzahl der Maschen pro Zoll Länge kleiner 200 und/oder größer 50 ist.

13. Abschirmgewebe (1) nach mindestens einem der vorhergehenden Ansprüche, **dadurch gekennzeichnet, dass** zusätzliche Fäden aus Kunststoff vorgesehen sind, die benachbart zu Metallfäden angeordnet sind und insbesondere dicht an Metallfäden anliegen.

14. Wandung, umfassend wenigstens eine faserverstärkte Außenschicht und ein Abschirmgewebe (1) nach wenigstens einem dem vorhergehenden Ansprüche.

## Claims

1. Screening fabric (1) with a wire cloth (2) continuously woven of threads (11-18, 21-28) over an extended fabric area, the threads comprising warp threads (11-18) and weave threads (21-28) extending transversely thereto and the warp threads and the weave threads being interconnected by way of at least one weave type, **characterized in that** at least part of the warp threads (11, 13, 15, 17) and weave threads (21, 23, 25, 27) consists of a metal, and that the warp threads (11, 13, 15, 17) and the weave threads (21, 23, 25, 27) are connected with one another to be electrically conducting, and that the wire cloth (2) comprises a weave type showing draping properties enhanced over a plain weave and based on a satin weave (3) and/or twill weave (4), and that part of the threads (12, 14, 16, 18, 22, 24, 26, 28) consists of a non-metal at least in part for enhancing the draping properties of the wire cloth (2).

2. The screening fabric (1) according to claim 1, **characterized in that** the weave type is based on a waffle weave.

3. The screening fabric (1) according to at least one of the preceding claims, **characterized in that** part of the warp threads and part of the weave threads consist of a non-metal at least in part wherein in particular some of the threads (12, 14, 16, 18, 22, 24, 26, 28) consist substantially entirely of a non-metal.

4. The screening fabric (1) according to at least one of the preceding claims, **characterized in that** some of the threads (12, 14, 16, 18, 22, 24, 26, 28) consist of a synthetic material at least in part.

5. The screening fabric (1) according to claim 4, **characterized in that** some of the threads comprise a fiber-reinforced core and a coat of a thermoplastic material.

6. The screening fabric (1) according to at least one of the preceding claims, **characterized in that** part of the threads comprise a metallic core and a coat of a non-metal.

7. The screening fabric (1) according to at least one of the preceding claims, **characterized in that** non-metallic threads are provided at periodic intervals.

8. The screening fabric (1) according to at least one of the preceding claims, **characterized in that** the wire cloth (2) is homogeneous across each area.

9. The screening fabric (1) according to at least one of the preceding claims, **characterized in that** the diameters (6) of synthetic and/or natural material threads (26) are less than 500 µm, in particular less than 250 µm, preferably less than 150 µm.

10. The screening fabric according to at least one of the preceding claims, **characterized in that** the diameters (7) of metallic threads (25) are less than 500 µm, in particular less than 150 µm, preferably less than 100 µm and/or wherein preferably a mesh size (5) is less than 500 µm and in particular less than 200 µm and preferably less than 150 µm.

11. The screening fabric (1) according to claim 10, **characterized in that** the mesh size (5) is approximately 150 µm and the diameter (7) of the metallic threads (25) is approximately 50 µm,

12. The screening fabric (1) according to at least one of the preceding claims, **characterized in that** a mesh count per inch of length is less than 200 and/or more than 50

13. The screening fabric (1) according to at least one of the preceding claims, **characterized in that** additional synthetic fibers are provided which are disposed adjacent to metallic threads and in particular disposed close to metallic threads.

14. Wall, comprising at least one fiber-reinforced external layer and a screening fabric (1) according to at least one of the preceding claims.

## Revendications

1. Tissu de blindage (1) comprenant une toile métallique (2) entièrement tissée base de fils (11-18, 21-28) sur une grande surface de toile, les fils comprenant des fils de chaîne (11-18) et des fils de trame perpendiculaires (21-28), et les fils de chaîne et les fils de trame étant liés les uns aux autres par au moins un type d'armure, **caractérisé en ce**
**qu'**au moins une partie des fils de chaîne (11, 13, 15, 17) et des fils de trame (21, 23, 25, 27) est en métal,
et en ce que les fils de chaîne (11, 13, 15, 17) et les fils de trame (21, 23, 25, 27) sont liés de façon à être électriquement conducteur,
et en ce que la toile métallique (2) présente un type d'armure qui présente, par rapport à une armure toile, une plus grande drapabilité et se base sur une armure satin (3) et/ou une armure sergé (4),
et en ce qu'une partie des fils (12, 14, 16, 18, 22, 24, 26, 28) est composée au moins partiellement d'un matériau non métallique pour augmenter la drapabilité de la toile métallique (2).

2. Tissu de blindage (1) selon la revendication 1, **caractérisé en ce que** le type d'armure se base sur une armure nid d'abeille.

3. Tissu de blindage (1) selon au moins l'une quelconque des revendications précédentes, **caractérisé en ce qu'**une partie des fils de chaîne et une partie des fils de trame sont composées au moins partiellement d'un matériau non métallique, certains fils (12, 14, 16, 18, 22, 24, 26, 28) notamment étant composés sensiblement en entier d'un matériau non métallique.

4. Tissu de blindage (1) selon au moins l'une quelconque des revendications précédentes, **caractérisé en ce que** certains fils (12, 14, 16, 18, 22, 24, 26, 28) sont composés au moins partiellement d'un matériau plastique.

5. Tissu de blindage (1) selon la revendication 4, **caractérisé en ce que** certains fils présentent un noyau renforcé de fibres et une gaine en matériau thermoplastique.

6. Tissu de blindage (1) selon au moins l'une quelconque des revendications précédentes, **caractérisé en ce qu'**une partie des fils présente un noyau métallique et une gaine non métallique.

7. Tissu de blindage (1) selon au moins l'une quelconque des revendications précédentes, **caractérisé en ce que** des fils non métalliques sont prévus à intervalles périodiques.

8. Tissu de blindage (1) selon au moins l'une quelconque des revendications précédentes, **caractérisé en ce que** la toile métallique (2) est homogène par zones.

9. Tissu de blindage (1) selon au moins l'une quelconque des revendications précédentes, **caractérisé en ce que** le diamètre (6) des fils en matériau plastique et/ou naturel est inférieur à 500 µm, notamment inférieur à 250 µm et de préférence inférieur à 150 µm.

10. Tissu de blindage selon au moins l'une quelconque des revendications précédentes, **caractérisé en ce que** le diamètre (7) des fils métalliques (25) est inférieur à 500 µm, notamment inférieur à 150 µm et de préférence inférieur à 100 µm, et/ou de préférence une largeur de maille (5) étant inférieure à 500 µm et notamment inférieure à 200 µm et de préférence inférieure à 150 µm.

11. Tissu de blindage (1) selon la revendication 10, **caractérisé en ce que** la largeur de maille (5) est d'environ 150 µm et le diamètre (7) des fils métalliques (25) d'environ 50 µm.

12. Tissu de blindage (1) selon au moins l'une quelconque des revendications précédentes, **caractérisé en ce que** le nombre de mailles par pouce de longueur est inférieur à 200 et/ou supérieur à 50.

13. Tissu de blindage (1) selon au moins l'une quelconque des revendications précédentes, **caractérisé en ce que** sont prévus des fils supplémentaires en matériau plastique, agencés dans le voisinage des fils métalliques et notamment à une position très rapprochée des fils métalliques.

14. Paroi, comprenant au moins une couche extérieure renforcée de fibres et un tissu de blindage (1) selon au moins l'une quelconque des revendications précédentes.
